# EUROPEAN PATENT APPLICATION

(11) **EP 4 549 957 A1**
(43) Date of publication of application: **07.05.2025**
(21) Application number: 23206914.6
(22) Date of filing: 31.10.2023
(51) Int. Cl.: G01P 15/18, G01P 15/125, G01P 15/08

(54) **COMB STRUCTURE FOR MEMS ACCELEROMETER**

(71) Applicant: Murata Manufacturing Co., Ltd., Nagaokakyo-shi, Kyoto 617-8555 (JP)
(72) Inventor: LIUKKU, Matti, 00400 Helsinki (FI); KUISMA, Elina, 00320 Helsinki (FI)
(74) Representative: Boco IP Oy Ab

(57) **Abstract**

The disclosure describes an accelerometer comprising stator combs which are interdigitated with rotor combs so that capacitors are formed. The tops of all rotor combs are recessed in the z-direction from the top surface of the device layer by a first recess depth D1. The tops of some stator combs are recessed in the z-direction from the top surface of the device layer by a second recess depth D2 which is greater than D1.

## Description

### FIELD OF THE DISCLOSURE

This disclosure relates to MEMS accelerometers, and particularly to accelerometers where proof masses move both in the device plane and out of the device plane.

### BACKGROUND OF THE DISCLOSURE

MEMS accelerometers can be equipped with capacitors which are used to measure the movement of a proof mass.

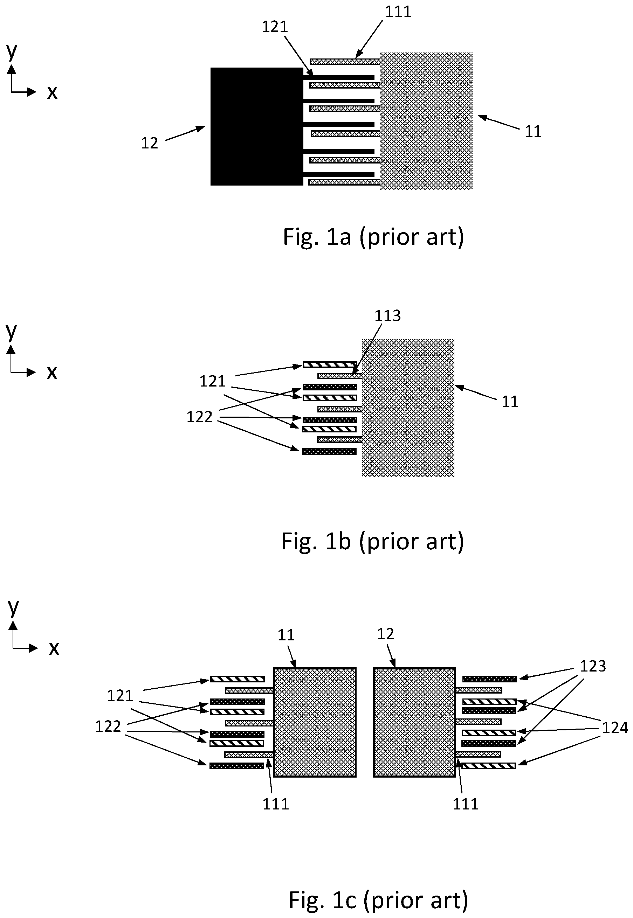

Figure 1a illustrates schematically a MEMS device with a single proof mass 11 which lies in an xy-plane (defined by the device layer where the proof mass was manufactured) in its rest position and a fixed structure 12 next to the proof mass. The fixed structure may be called a stator. The proof mass comprises a set of comb electrodes (such as 111) on the proof mass, which are interdigitated with corresponding comb electrodes (112) on the fixed structure 12. The proof mass 11 and the fixed structure 12 can together form a measurement capacitor and/or an actuation capacitor if they are made of a conducting or semiconducting material.

The comb arrangement illustrated in figure 1a allows any displacement of the proof mass 11 in relation to the fixed structure 12 in the y-direction to be detected as a change in capacitance. Alternatively, a voltage applied between the electrodes through a feedback loop can prevent the proof mass 11 from being displaced, and the magnitude of this voltage may be proportional to the acceleration experienced by the MEMS device.

It is also possible to implement two alternating and electrically separated sets of fixed comb fingers adjacent to a proof mass. A separate output signal can then be measured from each set. This has been illustrated in figure 1b, where fixed combs 121 form one set and fixed combs 122 form another set (the fixed structure which these combs are attached to has been omitted from the figure). Combs 121 form a first capacitor with proof mass combs 113, and combs 122 form a second capacitor with proof mass combs 113.

The arrangement illustrated in figure 1b facilitates a differential capacitive measurement, which can greatly improve the accuracy of capacitive measurements. In the capacitor illustrated in figure 1a, the measurement signal will exhibit a nonlinear dependence on proof mass displacement in the y-direction. In contrast, if the first capacitor (113+121) in figure 1b is designated C1 and the second (113+122) is designated C2, then C1 will increase when the proof mass 11 is displaced upward, while C2 will decrease. When the proof mass is displaced downward, C1 decreases while C2 increases. But the differential signal C1 - C2 will exhibit an ideal, almost linear dependence on the displacement of the proof mass in the y-direction. The differential arrangement illustrated in figure 1b also typically generates a stronger signal than the arrangement in figure 1a. It may also in some cases be less sensitive to mechanical stress since the comb electrodes on the fixed structure can be placed closer to each other.

Double differential measurements can in some applications be used to improve the accuracy further. Figure 1c illustrates a MEMS device with two proof masses 11 and 12 and four capacitors connected to these proof masses: 111+121 (with capacitance C1), 111+122 (with capacitance C2), 111+123 (with capacitance C3) and 111+124 (with capacitance C4). A double-differential signal (C1 - C2) + (C3 - C4) will not only exhibit a linear dependence on displacement in the y-direction, but also automatically cancel (at least in part) signal components arising from vibrational disturbances which are not intended to be measured. Such disturbances could for example include rotational movements which move one mass in the positive y-direction and the other in the negative y-direction.

The thermal noise level of the output signal depends on the size of the proof mass. When the proof mass is larger the thermal noise is smaller. Some accelerometers use a separate proof mass to measure acceleration in each direction. In other words, one proof mass responds to acceleration in the x-direction, another responds to acceleration in y-direction, another to z-acceleration. The movement of each proof mass is then measured separately. A general problem with this kind of arrangement is that each proof mass must be quite small due to area constraints, but a small proof mass leads to a high noise in each measured output signal.

Some accelerometers contain proof masses which are designed to respond to accelerations in the xy-plane and also to accelerations in a z-direction which is perpendicular to the xy-plane. When one proof mass can detect movement in multiple directions the proof can be made larger and so reduce the noise in each measured output signal. If multiple proof masses are used, they can be coupled with a coupling arrangement which synchronizes their movement response.

However, proof mass movements in different directions must be distinguishable from each other in this measurement arrangement. One way to do this is to build separate measurement capacitors for each direction (for example x, y and z). But significant reductions in size and complexity can be obtained if the same measurement capacitor can be used to measure movement in multiple directions (for example y and z). Such capacitors have to be carefully designed to ensure that a signal arising from displacement in one direction (for example y) can be reliably distinguished from a signal arising from (possibly simultaneous) displacement in the other direction it is designed to measure (in this case z).

### BRIEF DESCRIPTION OF THE DISCLOSURE

An object of the present disclosure is to provide a measurement arrangement which measures proof mass displacement in two perpendicular directions with high accuracy.

The object of the disclosure is achieved by an arrangement which is characterized by what is stated in the independent claim. The preferred embodiments are disclosed in the dependent claims. The measurement arrangement is based on a particular pattern of recessed combs structures.

### BRIEF DESCRIPTION OF THE DRAWINGS

In the following the disclosure will be described in greater detail by means of preferred embodiments with reference to the accompanying drawings, in which
Figures 1a - 1c illustrate MEMS devices known from the prior art.
Figures 2a - 2d illustrate MEMS devices according to a first embodiment.
Figures 3a - 3b illustrate comb heights in both the first and second embodiments.
Figure 4 illustrates a MEMS device according to a second embodiment.

### DETAILED DESCRIPTION OF THE DISCLOSURE

This disclosure describes a microelectromechanical accelerometer comprising one or more proof masses in a device layer. The device layer defines an xy-plane and a z-direction which is perpendicular to the xy-plane. The one or more proof masses comprise a first set of rotor combs which extend in an x-direction and a second set of rotor combs which also extend in the x-direction.

The accelerometer comprises four sets of stator combs in the device layer. These combs extend in the x-direction. Each of the four sets of stator combs is electrically insulated from the other three of the four sets of stator combs. The one or more proof masses are mobile at least in the y-direction and the z-direction in relation to the four sets of stator combs.

The four sets of stator combs comprise a first set of stator combs and a second set of stator combs which are interdigitated with the first set of rotor combs so that each rotor comb in the first set of rotor combs is flanked by:
- a stator comb from the first set of stator combs on one side and by
- a stator comb from the second set of stator combs on the opposite side.

The first set of stator combs thereby forms a first capacitor with the first set of rotor combs, and the second set of stator combs forms a second capacitor with the first set of rotor combs.

The four sets of stator combs also comprise a third set of stator combs and a fourth set of stator combs which are interdigitated with the second set of rotor combs so that each rotor comb in the second set of rotor combs is flanked by:
- a stator comb from the third set of stator combs on one side and by
- a stator comb from the fourth set of stator combs on the opposite side.

The third set of stator combs thereby forms a third capacitor with the second set of rotor combs, and the fourth set of stator combs forms a fourth capacitor with the second set of rotor combs.

The device layer has a top surface and a bottom surface which are parallel to the xy-plane and face in opposite z-directions. The bottoms of all rotor combs in the first and second sets of rotor combs and of all stator combs in the four sets of stator combs are level with each other.

The tops of all stator combs in the first set of stator combs and the tops of all stator combs in the fourth set of stator combs are level with the top surface of the device layer. The tops of all rotor combs in the first and second set of rotor combs are recessed in the z-direction from the top surface of the device layer by a first recess depth D1. The tops of all stator combs in the second set of stator combs and the tops of all stator combs in the third set of stator combs are recessed in the z-direction from the top surface of the device layer by a second recess depth D2. D2 is greater than D1.

The proof masses may also be called rotors. The proof masses described in this disclosure can undergo linear motion and/or rotational motion in relation to a fixed structure. This motion can occur in the xy-plane (which may also be called the device plane) or out of the xy-plane. In-plane and out-of-plane motion may occur simultaneously. The term "rotor comb" refers to an elongated structure which forms a part of a proof mass and can be used to measure the movement of the proof mass (together with an adjacent stator comb).

A fixed structure which is adjacent to the rotor may be called a stator. The term "stator comb" refers to an elongated structure which forms a part of a fixed structure and can be used to measure the movement of the proof mass (together with an adjacent rotor comb). Both the rotor and the stator may be formed in the device layer. The device layer may for example be a silicon wafer or a layer of silicon deposited on a carrier layer. Rotor combs may be interdigitated with stator combs to form capacitors, as described in more detail below. The capacitors described in any embodiment of this disclosure may be used as measurement capacitor or actuation capacitors.

In any embodiment presented in this disclosure, each of the first and second sets of rotor combs and each of the four sets of stator combs may contain a large number of combs, for example more than 20, more than 50 or more than 100 combs.

In any embodiment of this disclosure, the one or more proof masses may be configured to undergo a displacement in response to acceleration in the x-, y- and z-directions. This displacement may be in-plane movement in the case of acceleration in the x- and y-directions, and it may be out-of-plane movement in the case of acceleration in the z-direction. This disclosure will primarily focus on describing how these displacements can be measured.

However, proof mass displacement does not necessarily have to occur. The accelerometer may also be implemented with a signal feedback loop which performs a force-feedback function. The capacitors are then configured to function as actuators which keep the one or more proof masses stationary even when the accelerometer undergoes acceleration. The voltage which is needed at each actuation capacitor could keep the proof masses stationary can be recorded, and this value is proportional to the magnitude of the acceleration. All the benefits of differential and double-differential measurements described in this disclosure are also achieved in the force feedback implementation. This is because there is a direct correspondence between (a) the capacitive measurement signal that a given amount of proof mass displacement generates in a given capacitor (if the proof mass is allowed to move) and (b) the capacitive actuation signal that must be applied to the same capacitor in order to prevent the same proof mass from moving (in the force-feedback embodiment).

### First embodiment

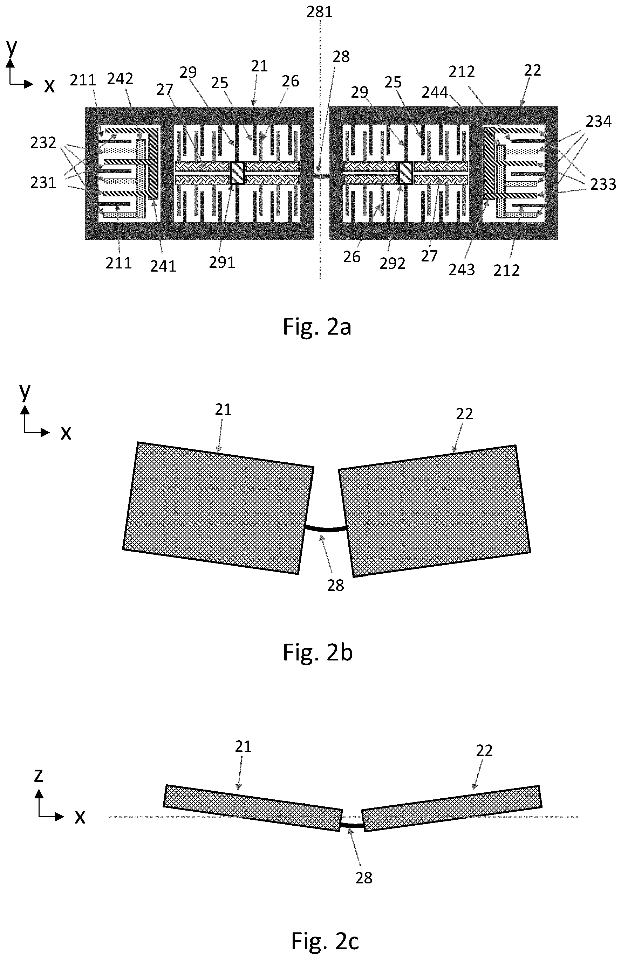

Figure 2a illustrates an accelerometer where the one or more proof masses comprise a first proof mass 21 and a second proof mass 22, and the first proof mass 21 and the second proof mass 22 are configured to rotate out of the device plane in opposite rotational directions in response to acceleration in the z-direction. The first set of rotor combs lies on the first proof mass and the second set of rotor combs lies on the second proof mass. The rotation axes of the first proof mass and the second proof mass extends in the y-direction.

The first proof mass 21 is suspended from a first anchor point 291 and a second proof mass 22 is suspended from a second anchor point 292. The anchor points are a rigid part of the fixed structures of the MEMS accelerometers. The suspension structures 29 are flexible springs which allow the proof masses 21 and 22 to move when the accelerometer experiences acceleration. The rotation axes of the two proof masses lie on the illustrated suspension structures 29. The geometry of the suspension structures 29 could alternatively be more complex. The suspension structures 29 allow the corresponding proof mass to rotate about a rotation axis which extends in the y-direction, and they also allow the rotation within the xy-plane as figure 2b illustrates.

The proof masses 21 and 22 are connected to each other with a coupling spring 28. The anchor points and suspensions structures are shown inside an opening in the proof mass in figure 2a, but they could alternatively be located outside of the proof mass.

The suspension structures 29 and proof masses 21 and 22 may be designed so that the two proof masses rotate in opposite directions in the device plane when the accelerometer experiences acceleration in the y-direction, as figure 2b schematically illustrates. They may also be designed so that the two proof masses rotate in opposite directions out of the device plane when the accelerometer experiences acceleration in the z-direction, as figure 2c illustrates. The coupling springs may be designed so that it flexibly accommodates the anti-phase movement illustrated in figures 2b and 2c and rigidly resists in-phase movement where both proof masses would rotate in the same direction.

Even though figures 2b - 2c illustrate rotational motion, the capacitors described in this disclosure could alternatively be used to detect linear motion. In other words, the one or more proof masses may be suspended with a suspension arrangement which allows them to move linearly in the y and/or the z-direction. Consequently, the word "rotor" can in this disclosure refer to a body which rotates or to a body which moves linearly.

Optionally, the suspension structures 29 and proof masses 21 and 22 may be designed so that the two proof masses both move in linear translation in the same x-direction when the accelerometer experiences acceleration in the x-direction. This in-phase movement has not been illustrated.

Figure 2a illustrates a first set of rotor combs 211 on the first proof mass 21 and a second set of rotor combs 212 on the second proof mass 22. The first and second sets of rotor combs are shown inside openings in the proof masses 21 and 22, at the outer end (left edge of 21 / right edge of 22) of said proof mass. However, these sets could alternatively be located on the outside of the proof mass, and they could alternatively be placed at the inner end (right edge of 21, left edge of 22).

Figure 2a also illustrates a first set of stator combs 231, a second set of stator combs 232, a third set of stator combs 233 and a fourth set of stator combs 234. The first set 231 of stator combs is connected to a first fixed structure 241, the second set of stator combs 232 is connected to a second fixed structure 242, the third set 233 of stator combs is connected to a third fixed structure 243, and the fourth set of stator combs 234 is connected to a fourth fixed structure 244. These fixed structures 241 - 244 are electrically insulated from each other, so the four sets of stator combs 231 - 234 are also electrically insulated from each other. This facilitates four separate capacitive measurements between the rotor combs and the stator combs. The arrangement illustrated in figure 2a is only one option. The four sets of stator combs 231 - 234 may also be electrically insulated from each other by other means. The stator combs 231 - 234 are stationary, so they do not move in relation to the surrounding device package when the device undergoes acceleration. The details specified in this paragraph apply also to the second embodiment, presented below.

It can be seen in figure 2a that, at proof mass 21, each rotor comb 211 in the first set of rotor combs is flanked by a stator comb 231 from the first set of stator combs on one side and by a stator comb 232 from the second set of stator combs on the opposite side. Conversely, at proof mass 22, each rotor comb 212 in the second set of rotor combs is flanked by a stator comb 233 from the third set of stator combs on one side and by a stator comb 234 from the fourth set of stator combs on the opposite side. This true also in the second embodiment, presented below.

Optionally, each rotor comb 211 in the first set of rotor combs may be flanked by a stator comb 231 from the first set of stator combs on a side which faces in a positive y-direction, and by a stator comb 232 from the second set of stator combs on a side which faces in a negative y-direction, and each rotor comb 212 in the second set of rotor combs may be flanked by a stator comb 233 from the third set of stator combs on a side which faces in the positive y-direction and by a stator comb 234 from the fourth set of stator combs on a side which faces in the negative y-direction. In other words, the comb which is adjacent to rotor comb 211 in the positive y-direction (the upper side in figure 2a) is a stator comb 231 from the first set, while the comb which is adjacent to the same rotor comb 211 in the negative y-direction (lower side in figure 2a) is a stator comb 232 from the second set. And the comb which is adjacent to rotor comb 212 in the positive y-direction is a stator comb 233 from the first set, while the comb which is adjacent to the same rotor comb 212 in the negative y-direction (lower side in figure 2a) is a stator comb 234 from the second set. The details specified in this paragraph apply also to the second embodiment, presented below. Alternatively, each rotor comb 211 in the first set of rotor combs may be flanked by a stator comb 231 from the first set of stator combs on a side which faces in a positive y-direction, and by a stator comb 232 from the second set of stator combs on a side which faces in a negative y-direction, and each rotor comb 212 in the second set of rotor combs may be flanked by a stator comb 234 from the fourth set of stator combs on a side which faces in the positive y-direction and by a stator comb 233 from the third set of stator combs on a side which faces in the negative y-direction. The details specified in this paragraph may be implemented also in the second embodiment.

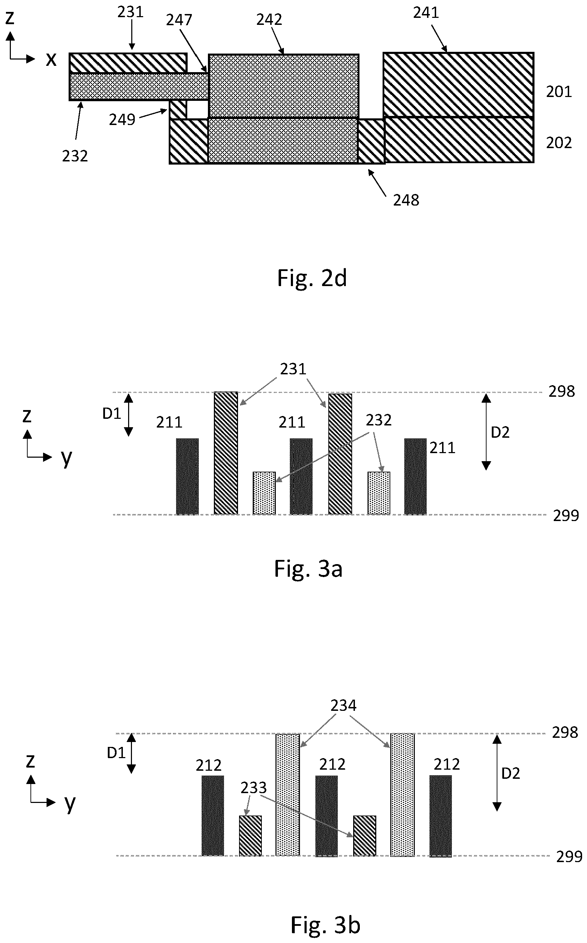

Since the four fixed structures 241 - 244 are electrically insulated from each other, the four sets of stator combs 231 - 234 are also insulated from each other (even though they lie in the same device layer, as figures 3a - 3b illustrate). Insulation (or physical separation, which also gives electrical separation) between adjacent stator comb sets can be manufactured in many different ways. The following options can be utilized in all embodiments presented in this disclosure.

The accelerometer may for example comprise an additional device layer, which may be formed by a silicon layer which is parallel to the device layer described previously in this disclosure and rigidly fixed to said device layer. This option is illustrated in figure 2d, where 201 is the device layer and 202 is the additional device layer. The combs 231 and 232 have different y-coordinates, as figure 2c shows. 247 indicates the interface between stator comb 232 and the second fixed structure 242.

The first fixed structure 241 extends past the second fixed structure 242 in the x-direction with the help of fixed extension structures 248 and 249 which are prepared in the additional device layer 202. The second fixed structure 242 may have a gap in the additional device layer 202 at the y-coordinate where the extension structure 248 is located. The bypass formed by 248 and 249 allows the stator comb 231 to be electrically separated from stator combs 232. The additional device layer 202 may also be used to form additional moving mass elements on proof masses 21 and 22. This option is not illustrated in figure 2d since it only shows fixed stator structures.

A fixed bypass structure with electrical conductivity (similar to the one in figure 2d) may in some applications be created even if a just single device layer is used. The vertical bypass structure, which may also be called a bridge structure, can for example be made of polysilicon. Another alternative is to not use fixed structures 241 - 244 at all, but to instead build each stator comb as a separate structure anchored to an underlying anchoring substrate. All combs that belong to the same set of stator combs 231, 232, 233 or 234) may then be connected to each other with electrical routings in the anchoring substrate.

The electrical separation (insulation) between adjacent stator combs sets forms four separate capacitors in figure 2a: a first capacitor between proof mass 21 and fixed structure 241 (comb sets 211+231), a second capacitor between proof mass 21 and fixed structure 242 (comb sets 211+232), a third capacitor between proof mass 22 and fixed structure 243 (comb sets 212+233) and a fourth capacitor between proof mass 22 and fixed structure 244 (comb sets 212+234).

The number of combs is very small in figure 2a for illustrative purposes. As mentioned previously, the number of combs will in practice be much larger. The number of rotor combs in the first set of rotor combs may be equal to the number of stator combs in first set of stator combs, and to the number of stator combs in the second set of stator combs. Similarly, the number of rotor combs in the second set of rotor combs may be equal to the number of stator combs in third set of stator combs and to the number of stator combs in the fourth set of stator combs. The number of rotor combs in the second set of rotor combs may also be equal to the number of rotor combs in the first set of rotor combs. The alternating comb order illustrated in figure 2a can be implemented for any number of rotor combs and stator combs. The details specified in this paragraph and the previous one apply also to the second embodiment.

Optionally, the accelerometer may contain additional comb structures which form additional capacitors that can be used to measure or actuate movement in the x-direction. For example, figure 2a illustrates additional fixed structures 27 inside within an opening in the proof masses 21 and 22, and additional stator combs 26 which extend in the y-direction from these fixed structures 27. Additional rotor combs 25 also extend in the y-direction within the opening. This option applies also to the second embodiment, but it is completely optional and the accelerometer can alternatively be implemented as a device where proof masses only move in the z-direction and the y-direction, not the x-direction.

The first and second proof masses 21 and 22 may be substantially mirror-symmetric with respect to a symmetry axis 281 which extends in the y-direction. The location and size of the first set of rotor combs 211 may be substantially mirror-symmetric with the location and size of the second set of rotor combs 212 with respect to the symmetry axis 281. The location and size of the first set of stator combs 231 may be substantially mirror-symmetric with the location and size of the third set of rotor combs 233 with respect to the symmetry axis 281. The location and size of the second set of stator combs 232 may be substantially mirror-symmetric with the location and size of the fourth set of rotor combs 234 with respect to the symmetry axis 281. Alternatively, 231 may be symmetric with 234 and 232 may be symmetric with 233.

The size and geometry of all rotor combs in the first and second sets may be substantially equal. But the size and geometry of the stator combs in the first, second, third and fourth sets may be unequal.

The following paragraphs, which discuss figures 3a - 3b, apply also to the second embodiment. Throughout this disclosure, the words "bottom" and "top" refer to two opposing sides of an object with different z-coordinates. Words such as "up" and "down" refer to two opposite z-directions. The z-axis is perpendicular to the device layer (the xy-plane). The device layer may be bonded, attached or deposited on an adjacent support layer either with its top side facing the support layer or with its bottom side facing the support layer. A capping layer may be attached to the other side (bottom or top).

Figures 3a and 3b illustrate in a schematic side view (yz cross-section) the same combs sets that are shown in figure 2a. They also illustrate a top surface 298 of the device layer and a bottom surface 299 of the device layer. It can be seen that the bottoms of stator combs 231 and 232 and rotor combs 211 are level with each other, and the bottoms of stator combs 233 and 234 and rotor combs 212 are also level with each other.

The bottoms of all sets of combs are in figures 3a and 3b also level with the bottom surface 299 of the device layer. Alternatively, they may all be recessed upward in the positive z-direction from the bottom surface 299 by the same amount (this option has not been illustrated).

However, some of the combs have been recessed from the top side. Firstly, both the first set 211 of rotor combs and the second set 212 of rotor combs have been recessed from the top surface 298 of the device layer by the first recess depth D1, as figures 3a - 3b illustrate. In other words, the sets 211 and 212 are recessed by the same amount. Secondly, the second set 232 of stator combs and the third set 233 of stator combs have been recessed from the top surface 298 by the second recess depth D2. In other words, the sets 232 and 233 are recessed by the same amount. D2 may, but does not necessarily have to be, twice as large as D1 in any embodiment presented in this disclosure.

In any embodiment presented in this disclosure, the distances D2 - D1 (i.e. in figure 3a the difference between the z-coordinate of the top of the smaller stator combs 232 and the z-coordinate of the top of the rotor combs 211) and D1 (i.e. in figure 3a the difference between the z-coordinate of the top of the rotor combs 211 and the top of the bigger stator combs 231) may both be at least 1,5 times the gap between each adjacent stator comb - rotor comb pair in the y-direction.

In any embodiment presented in this disclosure, the distances D2 - D1 and D1 may be greater than 3 micrometers. The height of the smaller stator combs (232 in figure 3a, 233 in figure 3b) in the z-direction may be greater than 5 micrometers. It may be in the range 10 - 25 micrometers or in the range 10 - 30 micrometers, or 20 - 30 micrometers. The height of the bigger stator combs (231 in figure 3a, 234 in figure 3b) may for example be in the range 35 - 80 micrometers, 40 - 80 micrometers or 40 - 60 micrometers, and it may be equal to the thickness of the device layer. The height of the rotor combs 211 may for example be in the range 25 - 40 micrometers or in the range 25 - 35 micrometers.

This comb geometry facilitates reliable measurement of proof mass displacement in both the y- and z-directions in a double-differential arrangement which includes the first (211 + 231), second (211 + 232), third (212 + 233) and fourth (212 + 234) capacitors. All of the one or more proof masses may be at the same electric potential in any embodiment. Alternatively, if there are two or more proof masses, they may be at different electric potentials.

It can be seen in figure 3a that proof mass displacement (which necessarily involves the displacement of rotor combs 211 and 212 in the same direction) in the positive z-direction increases the capacitance C1 of the first capacitor and the capacitance C4 of the fourth capacitor. The 211-231 and 212-234 overlap areas remain unchanged, but the increase comes from the additional area on the bottom of each rotor comb which is exposed toward a stator comb. The same displacement decreases the capacitance C2 of the second capacitor and the capacitance C3 of the third capacitor because the 211-232 and 212-233 overlap areas decrease.

Displacement in the negative z-direction, on the other hand, decreases C1 and C4 and increases C2 and C3. Displacement in the positive y-direction will increase C1 and C3 (due to a decrease in distance in the y-direction between rotor and stator combs) but decrease C2 and C4 (due to increased distance between rotor and stator combs). Conversely, displacement in the negative y-direction decreases C1 and C3 but increases C2 and C4.

A first differential signal S1 = C1 - C2 can be measured from the first and second capacitors. A second differential signal S2 = C3 - C4 can be measured from the third and fourth capacitors. The first and second differential signals may be analogue signals.

Double-differential signals can be calculated by adding or subtracting the S1 and S2 signals from each other. This calculation may be performed after signals S1 and S2 have been digitized. It can be shown that a first output signal DD1 = S1 - S2 will be proportional to proof-mass displacement in the z-direction but insensitive to displacement in the y-direction (i.e., DD1 remains substantially constant when the one or more proof masses move in the y-direction). A second output signal DD2 = S1 + S2 will be proportional to proof mass displacement in the y-direction but insensitive to displacement in the z-direction. Displacement in two perpendicular directions can thereby be reliable measured with this arrangement.

### Second embodiment

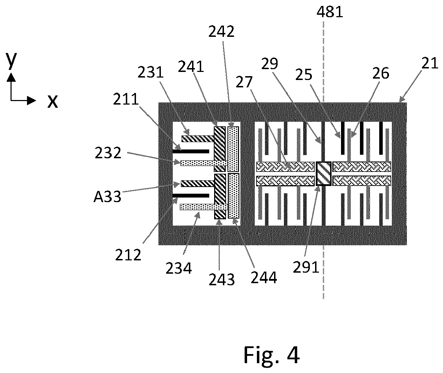

Figure 4 illustrates an embodiment where the one or more proof masses consist of a first proof mass 21. The first proof mass 21 is configured to rotate out of the device plane in response to acceleration in the z-direction. The rotation axis 481 of the first proof mass 21 extends in the y-direction.

Reference numbers 291, 29, 25 and 27 show the same optional elements in figure 4 as in figure 2a. Reference numbers 211 - 212, 231 - 234 and 241 - 244 also designate the same elements as in the first embodiment, but their placement differs from the first embodiment when only one proof mass is used.

The first (211) and second (212) sets of rotor combs are located within an opening in the first proof mass 21 in figure 4. The first (231), second (232), third (233) and fourth (234) sets of stator combs are located in the same opening. Alternatively, the first and/or the second set of rotor combs could be located outside of the proof mass 21 in the xy-plane, and the stator sets 231 + 232 and/or 233 + 234 could correspondingly be located outside of the proof mass 21.

Figure 4 illustrates just a single rotor comb in each set (211 and 212) for clarity. When further combs are added, the alternating order of the rotor and stator combs would correspond to the order illustrated in figure 2a.

As in the first embodiment the four fixed structures 241 - 244 are electrically insulated from each other, the four sets of stator combs 231 - 234 are also insulated from each other. Four separate capacitors are thereby formed, just as in figure 2a: a first capacitor between proof mass 21 and fixed structure 241 (comb sets 211+231), a second capacitor between proof mass 21 and fixed structure 242 (comb sets 211+232), a third capacitor between proof mass 21 and fixed structure 243 (comb sets 212+233) and a fourth capacitor between proof mass 21 and fixed structure 244 (comb sets 212+234).

The vertical recess scheme illustrated in figures 3a - 3b is applied in figure 4 as well. This allows two double-differential signals to be calculated, exactly as in the first embodiment. One of these indicates acceleration in the y-direction, while the other indicates acceleration in the z-direction, as described above in the first embodiment. Optional measurements can be conducted between combs 25 and 26 to detect acceleration in the x-direction. All features and options that were described above with reference to figures 3a - 3b also apply in this second embodiment.

## Claims

1. A microelectromechanical accelerometer comprising one or more proof masses in a device layer, wherein the device layer defines an xy-plane and a z-direction which is perpendicular to the xy-plane, and the one or more proof masses comprise a first set of rotor combs which extend in an x-direction and a second set of rotor combs which also extend in the x-direction,
and the accelerometer also comprises four sets of stator combs in the device layer which extend in the x-direction, and each of the four sets of stator combs is electrically insulated from the other three of the four sets of stator combs, and the one or more proof masses are mobile at least in the y-direction and the z-direction in relation to the four sets of stator combs, and
the four sets of stator combs comprise a first set of stator combs and a second set of stator combs which are interdigitated with the first set of rotor combs so that each rotor comb in the first set of rotor combs is flanked by:
- a stator comb from the first set of stator combs on one side and by
- a stator comb from the second set of stator combs on the opposite side,
whereby the first set of stator combs forms a first capacitor with the first set of rotor combs, and the second set of stator combs forms a second capacitor with the first set of rotor combs, and
the four sets of stator combs also comprise a third set of stator combs and a fourth set of stator combs which are interdigitated with the second set of rotor combs so that each rotor comb in the second set of rotor combs is flanked by:
- a stator comb from the third set of stator combs on one side and by
- a stator comb from the fourth set of stator combs on the opposite side,
whereby the third set of stator combs forms a third capacitor with the second set of rotor combs, and the fourth set of stator combs forms a fourth capacitor with the second set of rotor combs, and
the device layer has a top surface and a bottom surface which are parallel to the xy-plane and face in opposite z-directions, and the bottoms of all rotor combs in the first and second sets of rotor combs and of all stator combs in the four sets of stator combs are level with each other,
**characterized in that** the tops of all stator combs in the first set of stator combs and the tops of all stator combs in the fourth set of stator combs are level with the top surface of the device layer, and the tops of all rotor combs in the first and second set of rotor combs are recessed in the z-direction from the top surface of the device layer by a first recess depth D1, and the tops of all stator combs in the second set of stator combs and the tops of all stator combs in the third set of stator combs are recessed in the z-direction from the top surface of the device layer by a second recess depth D2, and D2 is greater than D1.

2. A microelectromechanical accelerometer according to claim 1, wherein
each rotor comb in the first set of rotor combs is flanked by a stator comb from the first set of stator combs on a side which faces in a positive y-direction, and by a stator comb from the second set of stator combs on a side which faces in a negative y-direction, and
each rotor comb in the second set of rotor combs is flanked by a stator comb from the third set of stator combs on a side which faces in the positive y-direction and by a stator comb from the fourth set of stator combs on a side which faces in the negative y-direction.

3. A microelectromechanical accelerometer according to any preceding claim, wherein the one or more proof masses comprise a first proof mass and a second proof mass, and the first proof mass and the second proof mass are configured to rotate out of the device plane in opposite rotational directions in response to acceleration in the z-direction, and the first set of rotor combs lies on the first proof mass and the second set of rotor combs lies on the second proof mass, and the rotation axes of the first proof mass and the second proof mass extend in the y-direction.

4. A microelectromechanical accelerometer according to claim 3, wherein the first and second proof masses are substantially mirror-symmetric with respect to a symmetry axis which extends in the y-direction, and the location and size of the first set of rotor combs is substantially mirror-symmetric with the location and size of the second set of rotor combs with respect to the symmetry axis, and the location and size of the first set of stator combs is substantially mirror-symmetric with the location and size of the third set of rotor combs with respect to the symmetry axis, and the location and size of the second set of stator combs is substantially mirror-symmetric with the location and size of the fourth set of rotor combs with respect to the symmetry axis.

5. A microelectromechanical accelerometer according to any of claims 1-2, wherein the one or more proof masses consist of a first proof mass, and the first proof mass is configured to rotate out of the device plane in response to acceleration in the z-direction, and the rotation axis of the first proof mass extends in the y-direction.

6. A microelectromechanical accelerometer according to any preceding claim, wherein D2 is twice as large as D1.
